# EUROPÄISCHE PATENTSCHRIFT

(11) **EP 3 034 526 B1**
(45) Veröffentlichungstag und Bekanntmachung des Hinweises auf die Patenterteilung: **14.06.2017**
(21) Anmeldenummer: 14199274.3
(22) Anmeldetag: 19.12.2014
(51) Int. Cl.: C08F 255/02, C08F 226/06, H01L 31/00, C09D 123/04, C09D 4/06

(54) **Covernetzersysteme für Verkapselungsfolien**
Cover net systems for encapsulation films
Systèmes de co-réticulation pour feuilles d'encapsulage

(43) Veröffentlichungstag der Anmeldung: 22.06.2016
(73) Patentinhaber: Evonik Degussa GmbH, 45128 Essen (DE)
(72) Erfinder: Ulbricht, Daniel, 64295 Darmstadt (DE); Hein, Marcel, 63843 Niedernberg (DE); Kleff, Frank, 63486 Brüchköbel-Oberissigheim (DE); Schauhoff, Stephanie, 63225 Langen (DE); Ohlemacher, Jürgen, 61118 Bad Vilbel (DE)

(56) Entgegenhaltungen:
- EP-A1- 1 164 167
- EP-A2- 0 227 470
- WO-A1-2014/129573
- CN-A- 103 804 774
- CN-B- 102 504 715

## Beschreibung

Die vorliegende Erfindung betrifft eine erste Zusammensetzung **(A)** umfassend (i) mindestens eine Verbindung **(I)** ausgewählt aus der Gruppe bestehend aus Triallylisocyanurat, Triallylcyanurat, wobei die Verbindung **(I)** bevorzugt Triallylisocyanurat ist; und (ii) mindestens eine Verbindung **(II)** ausgewählt aus der Gruppe bestehend aus *N,N*-Diallylethanolamin, Diallylcarbamat. Daneben betrifft die vorliegende Erfindung auch eine zweite Zusammensetzung **(B)** umfassend die erste Zusammensetzung **(A)** und mindestens ein Polyolefincopolymer. Schließlich betrifft die vorliegende Erfindung die Verwendung der Zusammensetzung **(B)** zur Herstellung einer Folie zur Verkapselung einer elektronischen Vorrichtung, insbesondere einer Solarzelle.

### Hintergrund der Erfindung

Photovoltaikmodule (Photovoltaik = "PV") bestehen üblicherweise aus einer Lage symmetrisch angeordneter Siliziumzellen, welche in zwei Lagen einer Schutzfolie eingeschweißt werden. Diese Schutzfolie ist selbst wiederum durch ein "*backsheet*" auf ihrer Rück- und ein "*frontsheet*" auf ihrer Vorderseite stabilisiert. "*Backsheet*" und "*frontsheet*" können sowohl geeignete Kunststofffolien sein als auch aus Glas bestehen. Die Funktion des Verkapselungsmaterials besteht im Wesentlichen darin, das PV-Modul vor Witterungseinflüssen und mechanischer Belastung zu schützen, weshalb die mechanische Stabilität des jeweiligen Verkapselungsmaterials eine wichtige Eigenschaft darstellt. Daneben weisen gute Verkapselungsmaterialien eine schnelle

Aushärtungsgeschwindigkeit, einen hohen Gelgehalt, eine hohe Transmission, eine geringe Neigung zu temperatur- und wärmeinduzierter Verfärbung sowie eine hohe Adhäsion (also eine geringe Neigung zur UV-induzierten Delaminierung) auf.

Die im Stand der Technik (zum Beispiel WO 2008/036708 A2) zu diesem Zweck beschriebenen Verkapselungsmaterialien beruhen typischerweise auf Materialien wie Silikonharzen, Polyvinylbutyralharzen, lonomeren, Polyolefinfolien oder Ethylen-Vinylacetat-Copolymeren ("EVA"). Verfahren zur Herstellung solcher Verkapselungsfolien sind dem Fachmann geläufig (EP 1 164 167 A1). In diesen Verfahren werden die Vernetzer zusammen mit einem Polyolefincopolymer (und eventuell weiteren Additiven) zum Beispiel in einem Extruder homogen vermischt und dann zu einer Folie extrudiert. Das in der EP 1 164 167 A1 beschriebene Verfahren betrifft Verkapselungsfolien auf Basis von EVA, ist aber auch auf Folien aus anderen, zum Beispiel den vorgenannten, Materialien anwendbar. EP 0 227 470 offenbart einen transparenten Film, der hauptsächlich mit Triallylisocyanurat vernetztes Ethylen-Vinylacetat Copolymer enthält.

Die Verkapselung der Siliziumzellen erfolgt typischerweise in einem Vakuumlaminierofen (EP 2 457 728 A1). Dazu wird der Schichtaufbau des PV-Moduls vorbereitet und in einem Laminierofen (bestehend aus zwei durch eine Membran getrennten Kammern) zunächst langsam aufgeheizt. Dadurch erweicht das Polyolefincopolymer (zum Beispiel EVA). Gleichzeitig wird der Ofen evakuiert, um die Luft zwischen den Schichten zu entfernen. Dieser Schritt ist der kritischste und dauert zwischen 4 bis 6 Minuten. Im Anschluss daran wird das Vakuum über die zweite Kammer gebrochen, und über Anlegen eines Drucks werden die Schichten des Moduls miteinander verschweißt. Gleichzeitig wird bis zur Vernetzungstemperatur weiter aufgeheizt, wobei in diesem letzten Schritt dann die Vernetzung der Folie stattfindet.

Gerade EVA wird standardmäßig bei der Herstellung von Verkapselungsfolien für Solarmodule eingesetzt. Allerdings weist es auch einen geringeren spezifischen elektrischen Durchgangswiderstand p als etwa Polyolefinfolien auf. Dies macht den Einsatz von EVA-Folien als Verkapselungsmaterial unattraktiver, da gerade Verkapselungsmaterialien mit hohem spezifischem elektrischem Durchgangswiderstand p gewünscht sind.

Bei PV-Modulen stellt nämlich der sogenannte "PID"-Effekt (PID = "*potential induced degradation*") derzeit ein großes Qualitätsproblem dar. Unter dem Begriff PID versteht man eine spannungsbedingte Leistungsdegradation, hervorgerufen durch sogenannte "Leckströme" innerhalb des PV-Moduls.

Ursache für die schädlichen Leckströme ist neben dem Aufbau der Solarzelle die Spannungslage der einzelnen PV-Module gegenüber dem Erdpotential - bei den meisten ungeerdeten PV-Systemen sind die PV-Module einer positiven oder negativen Spannung ausgesetzt. PID tritt meistens bei einer negativen Spannung gegenüber Erdpotential auf und wird durch hohe Systemspannungen, hohe Temperaturen und hohe Luftfeuchtigkeit beschleunigt. In der Folge wandern Natriumionen aus dem Deckglas des PV-Moduls an die Grenzfläche der Solarzelle und verursachen dort Schäden ("*shunt*"), die zu Leistungsverlusten und sogar zum Totalverlust des PV-Moduls führen können.

Das Risiko des Eintretens eines PID-Effektes kann durch die Erhöhung des spezifischen elektrischen Durchgangswiderstands p der Verkapselungsfolien deutlich reduziert werden.

Der spezifische elektrische Durchgangswiderstand p oder auch Resistivität ("*volume resistivity*", im Folgenden auch abgekürzt als "*VR*") ist eine temperaturabhängige Materialkonstante. Er wird zur Berechnung des elektrischen Widerstands eines homogenen elektrischen Leiters genutzt. Der spezifische elektrische Durchgangswiderstand wird erfindungsgemäß mittels ASTM-D257 bestimmt.

Je höher der spezifische elektrische Durchgangswiderstand p eines Materials ist, desto geringer ist die Anfälligkeit von Photovoltaikmodulen gegenüber dem PID-Effekt. Eine wesentliche, positive Auswirkung bei der Steigerung des spezifischen elektrischen Durchgangswiderstands p von Verkapselungsfolien ist daher die Erhöhung der Lebensdauer und Effizienz von PV-Modulen.

Im Stand der Technik wird das Problem des PID-Effekts im Zusammenhang mit Verkapselungsfolien für PV-Module in der CN 103525321 A diskutiert. Diese Schrift beschreibt eine EVA-basierte Folie zur Verkapselung von Solarzellen, welche als Co-Vernetzer Triallylisocyanurat ("TAIC") und Trimethylolpropantrimethacrylat ("TMPTMA") sowie als weitere Additive bevorzugt ein Polyolefinionomer und ein Polysiloxan zur Hydrophobisierung enthält. Diese Folie weist einen verminderten PID-Effekt auf. Nachteilig an ihr ist allerdings, dass Polyolefinionomere relativ teuer sind. Außerdem wirken sich Polysiloxane negativ auf die Haftungseigenschaften aus. Zudem werden in den Beispielen keine spezifischen Angaben darüber gemacht, mit welchen Konzentrationen welche Verbesserungen erreicht werden können.

Eine Vernetzerkombination aus TAIC und TMPTMA beschreibt auch die JP 2007-281135 A. Das TMPTMA bewirkt hierbei eine Beschleunigung der Vernetzungsreaktion und führt damit zu einer erhöhten Produktivität.

Die JP 2012-067174 A und die JP 2012-087260 A beschreiben eine auf EVA bzw. einem Polyolefin basierende Verkapselungsfolie für Solarzellen, die neben TAIC zum Beispiel Ethylenglykoldimethacrylat, Neopentylglykoldimethacrylat, 1,6-Hexandioldimethacrylat als Vernetzer aufweist. Diese Co-Crosslinker verlangsamen die Vernetzungsreaktion am Anfang etwas und erhöhen dadurch das Verarbeitungszeitfenster.

Die JP 2009-135200 A beschreibt ebenfalls Vernetzer umfassend TAIC und verschiedene (Meth)acrylatderivate polyfunktioneller Alkohole, wobei in diesem Fall eine verbesserte Hitzebeständigkeit verbunden mit einer geringeren Tendenz zur Delamination der EVA-basierten Verkapselung beschrieben wird.

Die JP 2007-281135 A und die JP 2007-305634 A beschreiben Vernetzerkombinationen aus TAIC und Trimethylolpropantriacrylat ("TMPTA") zur Verwendung bei der Herstellung von mehrschichtigen co-extrudierten EVA-Verkapselungsfolien für Solarzellen.

Ähnliche Kombinationen von Vernetzern für Solarzellenverkapselungsfolien beschreiben z. B. die JP 2013-138094 A, JPH11-20094, JPH11-20095, JPH11-20096, JPH11-20097, JPH11-20098, JPH11-21541, CN 102391568 A, CN 102504715 A, CN 102863918 A, CN 102911612 A, CN 103045105 A, CN 103755876 A, CN 103804774 A, US 2011/0160383 A1, WO 2014/129573 A1.

Demnach besteht ein Bedürfnis hinsichtlich neuer Covernetzersysteme, insbesondere zur Herstellung von Verkapselungsfolien für Solarzellen, die im Vergleich zu Folien, die nach dem Stand der Technik vernetzt sind, zu einem deutlich erhöhten elektrischen Durchgangswiderstand führen, um so beim Einsatz in Photovoltaikmodulen zu einer Verringerung des PID-Risikos führen.

Aufgabe der vorliegenden Erfindung war es deshalb, neue Zusammensetzungen zur Verfügung zu stellen, die zur Herstellung von Folien mit möglichst hohem spezifischen elektrischen Durchgangswiderstands p verwendet werden können und sich somit besonders zur Verkapselung von elektronischen Vorrichtungen wie zum Beispiel Solarzellen eignen. Diese Zusammensetzungen sollten außerdem in den etablierten Prozessen einsetzbar sein und die Kosten der Folien nicht wesentlich erhöhen. Insbesondere sollten Sie nicht die Nachteile aufweisen, die bei den Covernetzersystemen des Standes der Technik, und hier insbesondere bei jenen in der CN 103525321 A genannten Zusammensetzungen, beobachtet werden.

Es wurde nun überraschend gefunden, dass mit Hilfe bestimmter Zusammensetzungen eine Verkapselungsfolie für Solarzellen erhalten werden kann, die diese Anforderungen erfüllt. Die hier gefundenen Zusammensetzungen erhöhen den Volumenwiderstand erheblich bei vergleichsweise kleinen Einsatzmengen, ohne andere Folieneigenschaften negativ zu beeinflussen. Die Folien haben eine exzellente Verarbeitbarkeit, eine hohe Transparenz und exzellente UV- und Wärmealterungseigenschaften.

### Detaillierte Beschreibung der Erfindung

Die Covernetzersysteme gemäß der vorliegenden Erfindung können überraschend zur Herstellung von Folien zur Verkapselung von elektronischen Vorrichtungen wie zum Beispiel Solarzellen mit einem hohen spezifischen Durchgangswiderstand verwendet werden.

Das erfindungsgemäße Covernetzersystem ist demnach eine Zusammensetzung **(A)** umfassend (i) mindestens eine Verbindung **(I)** ausgewählt aus der Gruppe bestehend aus Triallylisocyanurat, Triallylcyanurat; und (ii) mindestens eine Verbindung **(II)** ausgewählt aus der Gruppe bestehend aus *N,N*-Diallylethanolamin, Diallylcarbamat;
wobei mindestens eine von der Zusammensetzung **(A)** umfasste Verbindung **(II)** in einem Anteil von mindestens 0.5 Gew.-%, insbesondere im Bereich 1.0 Gew.-% bis 33.7 Gew.-%, bevorzugt 2.0 Gew.-% bis 11.4 Gew.-%, bevorzugter 2.1 Gew.-% bis 8.51 Gew.-%, noch bevorzugter bei 4.2 Gew.-% bis 5.0 Gew.-%, jeweils bezogen auf das Gesamtgewicht aller von der Zusammensetzung **(A)** umfassten Verbindungen **(I),** vorliegt.

In einer bevorzugten Ausführungsform der erfindungsgemäßen Zusammensetzung **(A)** handelt es sich bei der Verbindung **(I)** um Triallylisocyanurat.

Triallylisocyanurat (= "TAIC"), Triallylcyanurat (= "TAC"), *N,N*-Diallylethanolamin (CAS-Nummer: 17719-79-8) und Diallylcarbamat haben jeweils die folgenden chemischen Strukturen:

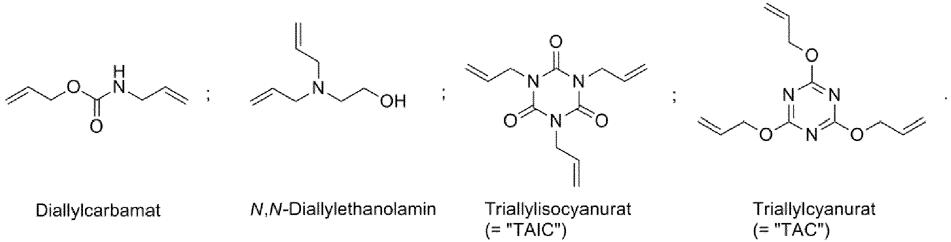

Der Ausdruck "mindestens eine von der Zusammensetzung **(A)** umfasste Verbindung **(II)** liegt in einem Anteil von mindestens 0.5 Gew.-%, bezogen auf das Gesamtgewicht aller von der Zusammensetzung **(A)** umfassten Verbindungen **(I),** vor" bedeutet, dass in der Zusammensetzung **(A)**
a) *N,N*-Diallylethanolamin in einer Menge von mindestens 0.5 Gew.-%, bezogen auf das Gesamtgewicht aller von Zusammensetzung **(A)** umfassten Verbindungen **(I)** vorliegt; und/oder
b) das Diallylcarbamt in einer Menge von mindestens 0.5 Gew.-%, bezogen auf das Gesamtgewicht aller von Zusammensetzung **(A)** umfassten Verbindungen **(I)** vorliegt.

In einer ersten bevorzugten Ausführungsform der vorliegenden Erfindung umfasst die Zusammensetzung **(A)** mindestens eine Verbindung **(I)** ausgewählt aus der Gruppe bestehend aus Triallylisocyanurat, Triallylcyanurat, wobei Triallylisocyanurat besonders bevorzugt ist; und als Verbindung **(II)** *N,N*-Diallylethanolamin, wobei in der Zusammensetzung **(A)** *N,N*-Diallylethanolamin in einem Anteil von mindestens 0.5 Gew.-%, bezogen auf das Gesamtgewicht aller von der Zusammensetzung **(A)** umfassten Verbindungen **(I),** vorliegt.

Noch bevorzugter liegt in dieser ersten Ausführungsform in der Zusammensetzung **(A)** *N,N*-Diallylethanolamin in einem Anteil von 1.0 Gew.-% bis 33.7 Gew.-%, bevorzugt 2.0 Gew.-% bis 11.4 Gew.-%, bevorzugter 2.1 Gew.-% bis 8.51 Gew.-%, noch bevorzugter 4.2 Gew.-% bis 5.0 Gew.-%, bezogen auf das Gesamtgewicht aller von der Zusammensetzung **(A)** umfassten Verbindungen **(I),** vor.

In einer zweiten bevorzugten Ausführungsform der vorliegenden Erfindung umfasst die Zusammensetzung **(A)** mindestens eine Verbindung **(I)** ausgewählt aus der Gruppe bestehend aus Triallylisocyanurat, Triallylcyanurat, wobei Triallylisocyanurat besonders bevorzugt ist; und als Verbindung **(II)** Diallylcarbamat, wobei in der Zusammensetzung **(A)** Diallylcarbamat in einem Anteil von mindestens 0.5 Gew.-%, bezogen auf das Gesamtgewicht aller von der Zusammensetzung **(A)** umfassten Verbindungen **(I),** vorliegt.

Noch bevorzugter liegt in dieser zweiten Ausführungsform in der Zusammensetzung **(A)** Diallylcarbamat in einem Anteil von 1.0 Gew.-% bis 33.7 Gew.-%, bevorzugt 2.0 Gew.-% bis 11.4 Gew.-%, bevorzugter 2.1 Gew.-% bis 8.51 Gew.-%, noch bevorzugter 4.2 Gew.-% bis 5.0 Gew.-%, bezogen auf das Gesamtgewicht aller von der Zusammensetzung **(A)** umfassten Verbindungen **(I),** vor.

Um die Homogenität der Folie und die Wirksamkeit der Folie zu gewährleisten, ist es wesentlich, dass mindestens eine von der Zusammensetzung **(A)** umfasste Verbindung **(II)** in einem Anteil von mindestens 0.5 Gew.-%, bezogen auf das Gesamtgewicht aller von der Zusammensetzung **(A)** umfassten Verbindungen **(I),** vorliegt. Dies gewährleistet, dass der spezifische Widerstand der damit erhältlichen Folien gerade die für großtechnische Anwendungen notwendigen Werte erreicht und eine ausreichende Verbesserung gegenüber den Vernetzersystemen des Standes der Technik erreicht wird. Zusammensetzungen, in denen keine einzige Verbindung **(II)** in einer solch ausreichenden Menge vorliegt, tragen nicht in ausreichendem Masse zur Erhöhung des spezifischen Widerstandes bei.

Es wurde überraschend festgestellt, dass sich die erfindungsgemäße Zusammensetzung **(A)** zur Verwendung als Covernetzer für Folien mit gegenüber dem Stand der Technik hohem spezifischen Widerstand eignen. Solche Folien eignen sich insbesondere zur Verkapselung von elektronischen Vorrichtungen, insbesondere Solarzellen. Dieser Effekt wird schon bei Zusammensetzungen **(A)** erreicht, wenn diese mindestens eine Verbindung **(I)** ausgewählt aus der Gruppe bestehend aus Triallylisocyanurat, Triallylcyanurat, wobei die Verbindung **(I)** insbesondere Triallylisocyanurat ist; und mindestens eine Verbindung **(II)** ausgewählt aus der Gruppe bestehend aus Diallylethanolamin, Diallylcarbamat umfasst.

Zusätzlich wurde aber auch überraschend festgestellt, dass bestimmte erfindungsgemäße Zusammensetzungen **(A)** weitere Vorteile mit sich bringen. Dies sind nämlich jene Zusammensetzungen **(A),** welche mindestens eine Verbindung **(I)** ausgewählt aus der Gruppe bestehend aus Triallylisocyanurat, Triallylcyanurat, wobei die Verbindung **(I)** insbesondere Triallylisocyanurat ist; und welche als Verbindungen **(II)** sowohl *N,N*-Diallylethanolamin als auch Diallylcarbamat umfassen. Bei Einsatz einer Mischung aus *N,N*-Diallylethanolamin und Diallylcarbamat als Verbindungen **(II)** in der Zusammensetzung **(A)** zeigt sich nämlich gegenübert den Fällen, in denen *N,N*-Diallylethanolamin bzw. Diallylcarbamat einzeln eingesetzt werden, ein synergistischer Effekt.

Deshalb betrifft die vorliegende Erfindung in einer dritten bevorzugten Ausführungsform die Zusammensetzung **(A)** umfassend mindestens eine Verbindung **(I)** ausgewählt aus der Gruppe bestehend aus Triallylisocyanurat, Triallylcyanurat, wobei Triallylisocyanurat besonders bevorzugt ist; und als Verbindungen **(II)** sowohl *N,N*-Diallylethanolamin als auch Diallylcarbamat,
wobei mindestens eine von der Zusammensetzung **(A)** umfasste Verbindung **(II)**, ausgewählt aus *N,N*-Diallylethanolamin, Diallylcarbamat, in einem Anteil von mindestens 0.5 Gew.-%, bezogen auf das Gesamtgewicht aller von der Zusammensetzung **(A)** umfassten Verbindungen **(I),** vorliegt.

Noch bevorzugter liegt in dieser dritten Ausführungsform in der Zusammensetzung **(A)** das Gesamtgewicht von *N,N*-Diallylethanolamin und Diallylcarbamat in der Zusammensetzung **(A)** bezogen auf das Gesamtgewicht aller von der Zusammensetzung **(A)** umfassten Verbindungen **(I)** im Bereich 1.0 Gew.-% bis 33.7 Gew.-%, bevorzugt 2.0 Gew.-% bis 11.4 Gew.-%, bevorzugter 2.1 Gew.-% bis 8.51 Gew.-%, noch bevorzugter bei 4.2 Gew.-% bis 5.0 Gew.-%.

Am bevorzugtesten liegt das Gewichtsverhältnis der Anteile von Diallylcarbamat und *N,N*-Diallylethanolamin in dieser dritten Ausführungsform der vorliegenden Erfindung in der Zusammensetzung **(A)** bei Diallylcarbamat : *N,N*-Diallylethanolamin = 99 : 1 bis 1 : 99, insbesondere 9 : 1 bis 1 : 9, bevorzugt 4 : 1 bis 1 : 4, bevorzugter 7 : 3 bis 3 : 7, noch bevorzugter 3 : 2 bis 2 : 3, am bevorzugtesten bei 1 : 1.

Die vorliegenden Covernetzersysteme werden bevorzugt zur Herstellung von Folien zur Verkapselung von elektronischen Vorrichtungen, z. B. Solarzellen in PV-Modulen, verwendet.

Dabei werden die Covernetzersysteme typischerweise zusammen mit Polyolefincopolymeren eingesetzt.

Die vorliegende Erfindung betrifft demnach auch eine Zusammensetzung **(B)** umfassend mindestens ein Polyolefincopolymer und die erfindungsgemäße Zusammensetzung **(A).**

Erfindungsgemäß einsetzbare Polyolefincopolymere sind dem Fachmann bekannt und etwa in der WO 2008/036708 A2 und der JP 2012-087260 beschrieben.

Insbesondere werden erfindungsgemäß als Polyolefincopolymere Ethylen/ α-Olefin-Interpolymere eingesetzt, wobei der Begriff "Interpolymer" bedeutet, dass das betreffende Polyolefincopolymer aus mindestens zwei verschiedenen Monomeren hergestellt wurde. Somit schließt der Begriff "Interpolymer" insbesondere Polyolefincopolymere aus genau zwei Monomereinheiten, aber auch Terpolymere (zum Beispiel Ethylen/Propylen/1-Octen, Ethylen/Propylen/Buten, Ethylen/Buten/1-Octen, Ethylen/Buten/Styrol) und Tetrapolymere ein.

Als Polyolefincopolymere kommen erfindungsgemäß insbesondere Ethylen/ α-Olefin-Copolymere, die bevorzugt neben Ethylen und dem α-Olefin keine weiteren Monomereinheiten aufweisen, in Frage, wobei im Sinne der Erfindung das "α-Olefin" bevorzugt ausgewählt ist aus der Gruppe bestehend aus Propen, 1-Buten, 4-Methyl-1-penten, 1-Hexen, 1-Octen, 1-Decen, 1-Dodecen, 1-Tetradecen, 1-Hexadecen, 1-Octadecen, 3-Cyclohexyl-1-propen, Vinylcyclohexan, Acrylsäure, Methacrylsäure, Norbornen, Styrol, Methylstyrol, Vinylacetat.

Noch bevorzugter ist das erfindungsgemäße Polyolefincopolymer in der Zusammensetzung **(B)** ein Ethylen-Vinylacetat-Copolymer.

Werden als Polyolefincopolymere Ethylen/ α-Olefin-Interpolymere eingesetzt, so weisen diese insbesondere einen α-Olefin-Gehalt im Bereich 15 bis 50 Gew.-%, bezogen auf das Gesamtgewicht des Ethylen/ α-Olefin-Interpolymers, auf. Bevorzugt liegt der α-Olefin-Gehalt dann im Bereich 20 bis 45 Gew.-%, bevorzugter im Bereich 25 bis 40 Gew.-%, noch bevorzugter 26 bis 34 Gew.-%, am bevorzugtesten 28 bis 33 Gew.-%, jeweils bezogen auf das Gesamtgewicht des Ethylen/ α-Olefin-Interpolymers.

In der bevorzugten Ausführungsform, in welcher es sich bei dem Polyolefincopolymer um ein Ethylen-Vinylacetat-Copolymer handelt, weist das Ethylen-Vinylacetat-Copolymer insbesondere einen Vinylacetat-Gehalt im Bereich 15 bis 50 Gew.-%, bezogen auf das Gesamtgewicht des Ethylen-Vinylacetat-Copolymers, auf. Bevorzugt liegt der Vinylacetat-Gehalt dann im Bereich 20 bis 45 Gew.-%, bevorzugter im Bereich 25 bis 40 Gew.-%, noch bevorzugter 26 bis 34 Gew.-%, am bevorzugtesten 28 bis 33 Gew.-% jeweils bezogen auf das Gesamtgewicht des Ethylen-Vinylacetat-Copolymers.

Der α-Olefin-Gehalt, insbesondere im Falle des Ethylen/ Vinylacetat-Copolymer der Gehalt an Vinylacetat, wird dabei mit dem in ASTM D 5594:1998 ["*Bestimmung des Vinylacetatgehalts von Ethylenvinylacetat(EVA)-Copolymeren mit Hilfe der Fourier-Transformations-Infrarotspektroskopie*"] beschriebenen Verfahren bestimmt.

Der Anteil der von der Zusammensetzung **(B)** umfassten Zusammensetzung **(A)** ist dabei nicht besonders beschränkt. Der Anteil der Zusammensetzung **(A)** in der Zusammensetzung **(B)** liegt insbesondere im Bereich von 0.05 bis 10 Gew.-%, bevorzugt im Bereich von 0.1 bis 5 Gew.-%, bevorzugter im Bereich von 0.2 bis 3 Gew.-%, noch bevorzugter bei 0.5 Gew.-%, jeweils bezogen auf die Masse aller von der Zusammensetzung **(B)** umfassten Polyolefincopolymere.

Die Zusammensetzung **(B)** eignet sich erfindungsgemäß zur Herstellung einer Verkapselungsfolie für elektronische Vorrichtungen, zum Beispiel Solarzellen. Sie wird dazu bei der Solarmodul-Lamination einer Vernetzungsreaktion unterzogen.

Zum Start der Vernetzungsreaktion ist es üblich, Initiatoren einzusetzen, also durch Wärme, Licht, Feuchtigkeit oder Elektronenstrahlen aktivierbare Radikalbildner.

In einer bevorzugten Ausführungsform der vorliegenden Erfindung umfasst die Zusammensetzung **(B)** deshalb auch einen Initiator ausgewählt aus der Gruppe bestehend aus peroxidischen Verbindungen, Azoverbindungen, Photoinitiatoren. Bevorzugter ist der Initiator ausgewählt aus der Gruppe bestehend aus peroxidischen Verbindungen, Azoverbindungen, noch bevorzugter eine peroxidische Verbindung. Beispiele dafür sind in der "Encyclopedia of Chemical Technology 1992, 3rd Edition, Vol. 17, Seiten 27 - 90" beschrieben.
Peroxidische Verbindungen sind insbesondere organische Peroxide, welche wiederum ausgewählt sind aus der Gruppe bestehend aus Dialkylperoxiden, Diperoxyketalen, Peroxycarbonsäureestern, Peroxycarbonaten, bevorzugt Peroxycarbonate.

Dialkylperoxide sind insbesondere ausgewählt aus der Gruppe bestehend aus Dicumylperoxid, Di-*tert*-butylperoxid, Di-*tert*-hexylperoxid, *tert*-Butylcumylperoxid, *iso*-Propylcumyl-*tert*-butylperoxid, *tert*-Hexylcumylperoxid, 2,5-Dimethyl-2,5-di(*tert*-butylperoxy)-hexan, 2,5-Dimethyl-2,5-di(*tert*-amylperoxy)-hexan, 2,5-Dimethyl-2,5-di(*tert*-butylperoxy)-hex-3-in, 2,5-Dimethyl-2,5-di(*tert*-amylperoxy)-hex-3-in, α,α-Di[(*tert*-butylperoxy)-*iso*-propyl]-benzol, Di-*tert*-amylperoxid, 1,3,5-Tri-[(*tert*-butylperoxy)-isopropyl]-benzol, 1,3-Dimethyl-3-(*tert*-butylperoxy)-butanol, 1,3-dimethyl-3-(*tert*-amylperoxy)-butanol, *iso*-Propylcumylhydroperoxid.

Diperoxyketale sind insbesondere ausgewählt aus der Gruppe bestehend aus 1,1-Di(*tert*-butylperoxy)-3,3,5-trimethylcyclohexan, 1,1-Di(*tert*-amylperoxy)-cyclohexan, 1,1-Di(*tert*-butylperoxy)-cyclohexan, *n*-Butyl-4,4-di(*tert*-amylperoxy)-valerat, Ethyl-3,3-di(*tert*-butylperoxy)-butyrat, 2,2-Di(*tert*-butylperoxy)butan, 3,6,6,9,9-Pentamethyl-3-ethoxycarbonylmethyl-1,2,4,5-tetraoxacyclononan, 2,2-Di(*tert*-amylperoxy)-propan, *n*-Butyl-4,4-bis(*tert*-butylperoxy)-valerat.

Peroxycarbonsäureester sind insbesondere ausgewählt aus der Gruppe bestehend aus *tert*-Amylperoxyacetat, *tert*-Butylperoxy-3,5,5-trimethylhexanoat, *tert*-Amylperoxybenzoat, *tert*-Butylperoxyacetat, *tert*-Butylperoxybenzoat, *OO*-*tert*-Butylmonoperoxysuccinat, *OO-tert*-Amylmonoperoxysuccinat.

Peroxycarbonate sind insbesondere ausgewählt aus der Gruppe bestehend aus *tert*-Butylperoxy-2-ethylhexylcarbonat, *tert*-Butylperoxy-iso-propylcarbonat, *tert*-Amylperoxy-2-ethylhexyl-carbonat, *tert*-Amylperoxybenzoat. Ein bevorzugtes Peroxycarbonat ist *tert*-Butylperoxy-2-ethylhexylcarbonat (im Folgenden auch abgekürzt als "TBPEHC").

Die Azoverbindung ist bevorzugt ausgewählt aus der Gruppe bestehend aus 2,2'-Azobis-(2-acetoxypropan), 1,1'-Azodi(hexahydrobenzonitril).

Besonders bevorzugt ist der Initiator ausgewählt aus der Gruppe bestehend aus 2,5-Dimethyl-2,5-di(*tert*-butylperoxy)-hexan, *tert*-Butylperoxy-2-ethylhexylcarbonat, *tert*-Butylperoxy-3,5,5-trimethylhexanoat, 1,1-Di(*tert*-butylperoxy)-3,5,5-trimethylcyclohexan, *tert*-Amylperoxy-2-ethylhexylcarbonat; am bevorzugtesten ist der Initiator *tert*-Butylperoxy-2-ethylhexylcarbonat.

Die Masse der peroxidischen Verbindung oder der Azoverbindung, bevorzugt der peroxidischen Verbindung, welche bezogen auf die Masse des Polyolefincopolymers eingesetzt wird, ist nicht besonders beschränkt. Die peroxidische Verbindung oder die Azoverbindung, bevorzugt die peroxidische Verbindung, wird insbesondere in einer Menge von 0.05 bis 10 Gew.-%, bevorzugt 0.1 bis 5 Gew.-%, bevorzugter 0.5 bis 2 Gew.-%, jeweils bezogen auf die Masse aller von der Zusammensetzung **(B)** umfassten Polyolefincopolymere, eingesetzt.

Photoinitiatoren sind insbesondere ausgewählt aus der Gruppe bestehend aus Benzophenon, Benzanthron, Benzoin, Benzoinalkylether, 2,2-Diethoxyacetophenon, 2,2-Dimethoxy-2-phenylacetophenon, *p*-Phenoxydichloracetophenon, 2-Hydroxycyclohexylphenon, 2-Hydroxyisopropylphenon, 1-Phenylpropandion-2-(ethoxycarbonyl)-oxim.

Der Photoinitiator wird insbesondere in einer Menge von 0.05 bis 10 Gew.-%, bevorzugt 0.1 bis 5 Gew.-%, bevorzugter 0.2 bis 3 Gew.-%, noch bevorzugter 0.25 bis 1 Gew.-%, jeweils bezogen auf die Masse aller von der Zusammensetzung **(B)** umfassten Polyolefincopolymere, eingesetzt.

In einer weiteren bevorzugten Ausführungsform der vorliegenden Erfindung umfasst die Zusammensetzung **(B)** auch mindestens eine weitere Verbindung ausgewählt aus der Gruppe bestehend aus Vernetzern, Silankupplungsmitteln, Antioxidantien, Alterungsschutzmittel, Metalloxiden, Metallhydroxiden, Weißpigmenten; wobei Silankupplungsmittel als weitere Verbindung bevorzugt sind.

Der Begriff "weitere Verbindung" impliziert dabei im Sinne der Erfindung, dass es sich bei dieser Verbindung nicht um Triallylisocyanurat, Triallylcyanurat, Diallylcarbamat oder *N,N*-Diallylethanolamin handelt.

Vernetzer sind dabei bevorzugt ausgewählt aus der Gruppe bestehend aus Trimethylolpropantriacrylat, Trimethylolpropantrimethacrylat, Divinylbenzol, Acrylate und Methacrylate von polyhydrischen Alkoholen. Acrylate und Methacrylate von polyhydrischen Alkoholen sind insbesondere ausgewählt aus der Gruppe bestehend aus Ethylenglycoldi(meth)acrylat, Diethylenglycoldi(meth)acrylat, Polyethylenglycoldi(meth)acrylat, Neopentylglycoldi(meth)acrylat, 1,6-Hexandioldi(meth)acrylat, 1,9-Nonandioldi(meth)acrylat, 1,10-Decandioldi(meth)acrylat.

Der Anteil der von der Zusammensetzung **(B)** umfassten Vernetzer ist dabei nicht besonders beschränkt. Der Anteil der Vernetzer in der Zusammensetzung **(B)** liegt insbesondere bei 0.005 bis 5 Gew.-%, bevorzugt 0.01 bis 3 Gew.-%, bevorzugter 0.05 bis 3 Gew.-%, noch bevorzugter 0.1 bis 1.5 Gew.-%, jeweils bezogen auf die Masse aller von der Zusammensetzung **(B)** umfassten Polyolefincopolymere.

Als erfindungsgemäß in der Zusammensetzung **(B)** einsetzbare Silankupplungsmittel kommen alle Silane in Betracht, welche einen ungesättigten Kohlenwasserstoffrest und einen hydrolysierbaren Rest aufweisen (beschrieben etwa in EP 2 436 701 B1, US 5,266,627).

Ungesättigte Kohlenwasserstoffreste sind insbesondere ausgewählt aus der Gruppe bestehend aus Vinyl, Allyl, Isopropenyl, Butenyl, Cyclohexenyl, γ-(Meth)acryloxyallyl.

Hydrolisierbarer Reste sind insbesondere ausgewählt aus der Gruppe bestehend aus Hydrocarbyloxy, Hydrocarbonyloxy, Hydrocarbylamino. Bevorzugt ist der hydrolysierbare Rest ausgewählt aus der Gruppe bestehend aus Methoxy, Ethoxy, Formyloxy, Acetoxy, Proprionyloxy, Alkylamino, Arylamino.

Bevorzugt ist das Silankupplungsmittel ausgewählt aus der Gruppe bestehend aus: Vinyltriethoxysilan, Vinyltris-(β-methoxyethoxy)silan, Vinyltriacetoxysilan, γ-Acryloxypropyltrimethoxysilan γ-Methacryloxypropyltrimethoxysilan, *N*-(β-aminoethyl)-γ-aminopropyltrimethoxysilan, *N*-(β-Aminoethyl)-γ-aminopropylmethyldimethoxysilan, γ-Aminopropyltriethoxysilan, γ-Glycidoxypropyltrimethoxysilan, γ-Mercaptopropyltriethoxysilan, γ-Chlorpropyltrimetoxysilan, β-(3,4-Ethoxycyclohexyl)-ethyltrimethoxysilan, γ-Mercaptopropyltrimethoxysilan. Besonders bevorzugt wird als Silankupplungsmittel γ-Methacryloxypropyltrimethoxysilan (abgekürzt als "KBM") eingesetzt.

Der Anteil des von der Zusammensetzung **(B)** umfassten Silankupplungsmittels ist dabei nicht besonders beschränkt. Der Anteil aller von der Zusammensetzung **(B)** umfassten Silankupplungsmittel liegt insbesondere bei 0.05 bis 5 Gew.-%, bevorzugt 0.1 bis 2 Gew.-%, jeweils bezogen auf die Masse aller von der Zusammensetzung **(B)** umfassten Polyolefincopolymere.

Antioxidantien sind im Sinne der Erfindung bevorzugt ausgewählt aus der Gruppe bestehend aus phenolischen Antioxidantien, phosphorhaltigen Antioxidantien.

Phenolische Antioxidantien sind insbesondere ausgewählt aus der Gruppe bestehend aus 4-Methoxyphenol, 2,6-Di-*tert*-butyl-4-methylphenol, *tert*-Butylhydrochinon, Stearyl-β-(3,5-di-*tert*-butyl-4-hydroxyphenyl)-propionat, Pentaerythrittetrakis-[3-(3,5-di-*tert*-butyl-4-hydroxyphenyl)-propionat], 3,5-Di-*tert*-butyl-4-hydroxybenzoesäurehexadecylester.

Phosphorhaltige Antioxidantien sind insbesondere ausgewählt aus der Gruppe bestehend aus Triphenylphosphit, Tris-(nonylphenyl)-phosphit, Distearylpentaerythritoldiphosphit, Tetra-(tridecyl)-1,1,3-tris-(2-methyl-5-*tert*-butyl-4-hydroxyphenyl)-butan-diphosphat, Tetrakis-(2,4-di-*tert*-butylphenyl)-4,4-biphenyldiphosphonit.

Der Anteil der von der Zusammensetzung **(B)** umfassten Antioxidantien ist dabei nicht besonders beschränkt. Der Anteil aller von der Zusammensetzung **(B)** umfassten Antioxidantien liegt insbesondere bei 0.01 bis 0.5 Gew.-%, bevorzugt 0.05 bis 0.3 Gew.-%, jeweils bezogen auf die Masse aller von der Zusammensetzung **(B)** umfassten Polyolefincopolymere.

Alterungsschutzmittel sind im Sinne der Erfindung insbesondere ausgewählt aus der Gruppe der"*hindered amine light stabilizers*" (= "HALS")-Stabilisatoren und der UV-Absorber.

HALS-Stabilisatoren sind im Sinne der Erfindung insbesondere Verbindungen, die mindestens einen 2,2,6,6-Tetramethyl-4-piperidyl-Rest aufweisen, wobei das Stickstoffatom an der 1-Position des Piperidylrestes ein H, eine Alkylgruppe oder eine Alkoxygruppe trägt.

Bevorzugt sind HALS-Stabilisatoren ausgewählt aus der Gruppe bestehend aus Bis(2,2,6,6-tetramethyl-4-piperidyl)-sebacat, 1,2,2,6,6-Pentamethyl-4-piperidylsebacat, Bis(1,2,2,6,6-pentamethyl-4-piperidyl)-sebacat,
Bis-(1-octyloxy-2,2,6,6-tetramethyl-4-piperidyl)-sebacat, Poly-{(6-morpholino-*S*-triazin-2,4-diyl)-[2,2,6,6-tetramethyl-4-piperidyl)-imino]-hexamethylen-[(2,2,6 ,6-tetramethyl-4-piperidyl)-imino]} mit der CAS-Nummer 82451-48-7,
Polymere der CAS-Nummer 193098-40-7,
Copolymer aus Dimethylsuccinat und 1-(2-Hydroxyethyl)-2,2,6,6-tetramentyl-4-piperidinol, *N,N',N",N*"'-Tetrakis-{4,6-bis-[butyl-(N-methyl-2,2,6,6-tetramethylpiperidin-4-yl)-amino]-triazin-2-yl}-4,7-diazadecan-1,10-diamin mit der CAS-Nummer 106990-43-6.

Der Anteil der von der Zusammensetzung **(B)** umfassten HALS-Stabilisatoren ist dabei nicht besonders beschränkt. Der Anteil aller von der Zusammensetzung **(B)** umfassten HALS-Stabilisatoren liegt insbesondere bei 0.01 bis 0.5 Gew.-%, bevorzugt 0.05 bis 0.3 Gew.-%, jeweils bezogen auf die Masse aller von der Zusammensetzung **(B)** umfassten Polyolefincopolymere.

UV-Absorber sind insbesondere ausgewählt aus der Gruppe bestehend aus 2-Hydroxy-4-*N*-octoxybenzophenon, 2,4-Di-*tert*-butylphenyl-3,5-di-*tert*-butyl-4-hydroxybenzoat, 2-Hydroxy-4-methoxybenzophenon, 2,2-Dihydroxy-4-methoxybenzophenon, 2-Hydroxy-4-methoxy-4-carboxybenzophenon, 2-(2-Hydroxy-3,5-di-*tert*-butylphenyl)-benzotriazol, 2-(2-Hydroxy-5-methylphenyl)-benzotriazol, p-Octyl-phenyl salicylat, 2-(4,6-Diphenyl-1,3,5-triazine-2-yl)-5-[(hexyl)-oxy]-phenol, Ethyl-2-cyano-3,3-diphenyl-acrylat.

Der Anteil der von der Zusammensetzung **(B)** umfassten UV-Absorber ist dabei nicht besonders beschränkt. Der Anteil aller von der Zusammensetzung **(B)** umfassten UV-Absorber liegt insbesondere bei 0.01 bis 0.5 Gew.-%, bevorzugt 0.05 bis 0.3 Gew.-%, jeweils bezogen auf die Masse aller von der Zusammensetzung **(B)** umfassten Polyolefincopolymere.

Metalloxide sind erfindungsgemäß insbesondere ausgewählt aus der Gruppe bestehend aus Alkalimetalloxiden, Erdalkalimetalloxiden, Zinkoxid, bevorzugt ausgewählt aus der Gruppe bestehend aus Magnesiumoxid, Zinkoxid.

Der Anteil der von der Zusammensetzung **(B)** umfassten Metalloxide ist dabei nicht besonders beschränkt. Der Anteil aller von der Zusammensetzung **(B)** umfassten Metalloxide liegt insbesondere bei 0.01 bis 10 Gew.-%, bevorzugt 0.05 bis 3 Gew.-%, jeweils bezogen auf die Masse aller von der Zusammensetzung **(B)** umfassten Polyolefincopolymere.

Metallhydroxide sind erfindungsgemäß insbesondere ausgewählt aus der Gruppe bestehend aus Alkalimetallhydroxiden, Erdalkalimetallhydroxiden, bevorzugt ausgewählt aus der Gruppe bestehend aus Magnesiumhydroxid, Calciumhydroxid.

Der Anteil der von der Zusammensetzung **(B)** umfassten Metallhydroxide ist dabei nicht besonders beschränkt. Der Anteil aller von der Zusammensetzung **(B)** umfassten Metallhydroxide liegt insbesondere bei 0.01 bis 10 Gew.-%, bevorzugt 0.05 bis 3 Gew.-%, jeweils bezogen auf die Masse aller von der Zusammensetzung **(B)** umfassten Polyolefincopolymere.

Weißpigmente sind im Sinne der Erfindung insbesondere ausgewählt aus der Gruppe Titandioxid, Zinkoxid, Zinksulfid, Bariumsulfat, Lithopone.

Der Anteil der von der Zusammensetzung **(B)** umfassten Weißpigmente ist dabei nicht besonders beschränkt. Der Anteil aller von der Zusammensetzung **(B)** Weißpigmente liegt insbesondere bei 5 bis 25 Gew.-%, bevorzugt 10 bis 20 Gew.-%, noch bevorzugter bei 15 Gew.-%, jeweils bezogen auf die Masse aller von der Zusammensetzung **(B)** umfassten Polyolefincopolymere.

Die Polymerzusammensetzung **(B)** wird in einem weiteren Aspekt der vorliegenden Erfindung zur Herstellung einer Folie zur Verkapselung einer elektronischen Vorrichtung, insbesondere einer Solarzelle, verwendet.

Dabei wird die Zusammensetzung **(B)** zunächst durch Mischen der Zusammensetzung **(A)** sowie den jeweiligen Additiven und dem Polyolefincopolymer hergestellt. Dies erfolgt insbesondere durch Zugabe der Additive in flüssiger Form, d.h. rein oder als Lösung in einem Lösungsmittel, zu der Zusammensetzung **(B)** in einem Mischer. Danach wird so lange gerührt oder die Mischung in Bewegung gehalten, bis die Flüssigkeit vollständig vom Polymergranulat absorbiert worden ist. Eventuell verwendete Lösemittel werden dann wieder durch Anlegen eines Vakuums entfernt.

In einem zweiten Schritt wird die Polymerformulierung über einen Extruder zu einem Film extrudiert. Hierbei wird die Zusammensetzung **(B)** kontinuierlich über eine Dosierschnecke in einen Extruder dosiert in dem das Poymer aufschmilzt und die Additive durch das Kneten der Mischung homogen in der Polymermatrix verteilt werden. Am Ende des Extruders wird die Schmelze durch eine Breitschlitzdüse gepresst. Nach der Düse wird die Folie durch ein Walzwerk abgezogen, nachgekühlt und aufgewickelt.

Alternativ können die Additive oder die Additivmischung auch direkt über den Einfüllstutzen oder über eine Seitendosierung in den Filmextruder dosiert werden.

Die nachfolgenden Beispiele sollen die vorliegende Erfindung weiter erläutern, ohne dass diese auf diese Beispiele beschränkt sein soll.

### Beispiele

### 1. Verwendete Chemikalien

*N,N*-Diallylethanolamin (CAS: 17719-79-8) wurde bezogen von Fluorochem Ltd.

Bei dem im Folgenden verwendeten Triallylisocyanurat (="TAIC") handelte es sich um "TAICROS ®" der Evonik Industries AG.

Bei dem im Folgenden verwendeten γ-Methacryloxypropyltrimethoxysilan (= "KBM") handelte es sich um "Dynasylan Memo ®" der Evonik Industries AG.

Bei dem im Folgenden verwendeten EVA handelte es sich um "EVATANE 28-40" ® von Arkema mit einem Gehalt an Vinylacetat von 28.3 Gew.-%.

Das im Folgenden verwendete *tert*-Butylperoxy-2-ethylhexylcarbonat (="TBPEHC") wurde von der Firma United Initiators bezogen.

Allylalkohol wurde bezogen von NovaCyl.

Allylisocyanat wurde bezogen von Sigma Aldrich.

Diallylcarbamat wurde wie folgt aus Allylalkohol und Allylisocyanat gewonnen:

### Synthese Diallylcarbamat

3 g (51.6 mmol) Allylalkohol (CAS: 107-58-3) wurden in 90 mL Dichlormethan gelöst. Als Base wurde NEt₃ zugesetzt. Bei Raumtemperatur wurden 5 g (60 mmol) Allylisocyanat (CAS: 1476-23-9) langsam zugetropft. Die Reaktionslösung wurde 2 Stunden auf 40 °C erwärmt. Die organische Phase wurde jeweils mit 20 %-iger NaCl-Lösung, gesättigter NaHCO₃-Lösung und destilliertem Wasser gewaschen, getrocknet und im Vakuum eingeengt. Man erhielt 6.3 g (44.9 mmol, Reinheit: 95 %) einer schwach gelb gefärbten Flüssigkeit. Die Charakterisierung erfolgte über NMR.

### 2. Herstellung der Beispiel-Formulierungen

### 2.1 Vergleichsbeispiel V1

2.49 g (10.0 mmol) TAIC, 0.5 g KBM und 4.0 g TBPEHC wurden homogen vermischt. Diese Mischung wurde auf 493 g EVA gleichmäßig verteilt. Die EVA-Additivmischung wurde anschließend für 2 bis 4 Stunden in einem Taumelmischer durchmischt.

### 2.2 Erfindungsgemäße Beispiele 1 bis 5

### Beispiel 1

0.05 g (0.36 mmol) Diallylcarbamat wurden zusammen mit 2.45 g (9.83 mmol) TAIC, 0.5 g KBM und 4.0 g TBPEHC homogen vermischt. Die Mischung wurde auf 493 g EVA gleichmäßig verteilt. Die EVA-Additivmischung wurde anschließend für 2 bis 4 Stunden in einem Taumelmischer durchmischt.

### Beispiel 2

0.1 g (0.71 mmol) Diallylcarbamat wurden zusammen mit 2.40 g (9.63 mmol) TAIC, 0.5 g KBM und 4.0 g TBPEHC homogen vermischt. Die Mischung wurde auf 493 g EVA gleichmäßig verteilt. Die EVA-Additivmischung wurde anschließend für 2 bis 4 Stunden in einem Taumelmischer durchmischt.

### Beispiel 3

0.049 g (0.35 mmol) *N,N-*Diallylethanolamin wurden zusammen mit 2.45 g (9.83 mmol) TAIC, 0.5 g KBM und 4.0 g TBPEHC homogen vermischt. Die Mischung wurde auf 493 g EVA gleichmäßig verteilt. Die EVA-Additivmischung wurde anschließend für 2 bis 4 Stunden in einem Taumelmischer durchmischt.

### Beispiel 4

0.1 g (0.71 mmol) *N,N*-Diallylethanolamin wurden zusammen mit 2.40 g (9.63 mmol) TAIC, 0.5 g KBM und 4.0 g TBPEHC homogen vermischt. Die Mischung wurde auf 493 g EVA gleichmäßig verteilt. Die EVA-Additivmischung wurde anschließend für 2 bis 4 Stunden in einem Taumelmischer durchmischt.

### Beispiel 5

0.05 g (0.36 mmol) Diallylcarbamat und 0.049 g (0.35 mmol) *N,N-*Diallylethanolamin wurden zusammen mit 2.40 g (9.63 mmol) TAIC, 0.5 g KBM und 4.0 g TBPEHC homogen vermischt. Die Mischung wurde auf 493 g EVA gleichmäßig verteilt. Die EVA-Additivmischung wurde anschließend für 2 bis 4 Stunden in einem Taumelmischer durchmischt.

### 3. Folienextrusion

Zur Herstellung der EVA-Folien wurde das konditionierte EVA-Granulat, welches wie im Vergleichsbeispiel und den erfindungsgemäßen Beispielen 1 bis 5 beschrieben hergestellt worden war, volumetrisch in einem Doppelschnecken-Laborextruder (Collin) dosiert. Die EVA-Schmelze wurde über eine Breitschlitzdüse (10 cm) mit einstellbarer Spaltdicke verdüst, die Folie kontinuierlich auf einem Walzwerk auf 20 °C nachgekühlt und anschließend aufgewickelt. Die Extruder-Einstellungen sind nachstehend aufgeführt:

| Temperatur der Heizzonen für EVA-Folienherstellung [°C] | |
|---|---|
| T1 | 70 |
| T2 | 77 |
| T3 | 77 |
| T4 | 75 |
| T5 | 80 |
| Düse | 80 |
| T(Schmelze) | 87 - 90 |

### 4. Folienlamination

Die Lamination der EVA-Folie wurde bei 150 °C (Maschineneinstellung) zwischen Teflon-Trennfolien durchgeführt, wobei die entsprechende Temperatur über den gesamten Laminationsprozess konstant gehalten wurde. Die Dauer des einstufigen Entgasungsschrittes betrug 100 s. Anschließend wurde die Probe mit einem Anpressdruck von 0.7 kg/cm² verpresst. Die Verweilzeit im Laminator betrug 20 Minuten.

### 5. Bestimmung des spezifischen Widerstands ρ

Für die Bestimmung des Widerstandes von vernetzten, 400 bis 500 µm starken EVA Folien wurden zunächst Proben mit den Abmaßen ca. 8 x 8 cm bei Raumtemperatur (22.5 °C) und einer relativen Luftfeuchte von 50 % für einen Zeitraum von 7 Tagen gelagert, um ein konstantes Feuchtigkeitslevel innerhalb des EVA Films zu gewährleisten.

Die Widerstandsmessung wurde mit einem Ohmmeter der Firma Keithley (6517B) und einer entsprechenden Messzelle, ebenfalls von Keithley ("*resistivity test fixture 8009"),* durchgeführt. Nach ASTM D-257 wurde die Probe mit einer Spannung von 500 V für 60 s beaufschlagt und nach dieser Zeit der Strom gemessen. Der Widerstand (VR) lässt sich dann aus den bekannten Größen berechnen.

### 6. Ergebnisse der Widerstandsmessungen der Beispielformulierungen

Die folgende Tabelle 1 gibt eine Übersicht über die im jeweiligen Beispiel gemessenen VR-Werte:

**Tabelle 1:**

| Beispiel Nr. | TAIC in mmol; Gewicht in "[ ]" | Diallyl-carbamat in mmol; Gewicht in "[ ]" | *N,N*-Diallyl-ethanolamin in mmol; Gewicht in "[ ]" | Anteil der Gesamtmenge aus Diallyl-carbamat und N,N-Diallylethanolamin bez. auf TAIC in mol.-% | Anteil der Gesamtmenge aus Diallylcarbamat und N,N-Diallylethanolamin bez. auf TAIC in Gew.-% | VR * 10¹⁵ [Ohm*cm] |
|---|---|---|---|---|---|---|
| V1 | 10 [2.49 g] | - | - | - | - | 3.77 |
| 1 | 9.83 [2.45 g] | 0.36 [0.05 g] | - | 3.7 | 2.1 | 3.85 |
| 2 | 9.63 [2.40 g] | 0.71 [0.10 g] | - | 7.4 | 4.2 | 4.2 |
| 3 | 9.83 [2.45 g] | - | 0.35 [0.049 g] | 3.6 | 2.0 | 5.2 |
| 4 | 9.63 [2.40 g] | - | 0.71 [0.100 g] | 7.4 | 4.2 | 5.1 |
| 5 | 9.63 [2.40 g] | 0.36 [0.05 g] | 0.35 [0.049 g] | 7.4 | 4.2 | 5.3 |

Die in Tabelle 1 dargestellten Ergebnisse belegen, dass mit dem erfindungsgemäßen Covernetzersystem, also Zusammensetzung **(A),** Folien mit einem hohen spezifischen Widerstand erhalten werden können. So sind sämtliche VR-Werte der mit dem erfindungsgemäßen Coverentzersystem hergestellten Folien höher als der Wert der Folie, die mit einem Vernetzer des Standes der Technik, TAIC, erhalten wurde.

Zusätzlich belegt ein Vergleich des im Beispiel 5 gemessenen VR-Wertes mit den in den übrigen Beispielen 1 bis 4 gemessenen, dass ein synergistischer Effekt bei der Verwendung der Kombination von *N,N*-Diallylethanolamin und Diallylcarbamat beobachtet werden kann, der zu einem besonders hohen VR-Wert führt.

## Patentansprüche

1. Zusammensetzung **(A)** umfassend
(i) mindestens eine Verbindung **(I)** ausgewählt aus der Gruppe bestehend aus Triallylisocyanurat, Triallylcyanurat; und
(ii) mindestens eine Verbindung **(II)** ausgewählt aus der Gruppe bestehend aus *N,N*-Diallylethanolamin, Diallylcarbamat;
wobei mindestens eine von der Zusammensetzung **(A)** umfasste Verbindung **(II)** in einem Anteil von mindestens 0.5 Gew.-%, bezogen auf das Gesamtgewicht aller von der Zusammensetzung **(A)** umfassten Verbindungen **(I),** vorliegt.

2. Zusammensetzung **(A)** nach Anspruch 1, wobei die Verbindung **(I)** Triallylisocyanurat ist.

3. Zusammensetzung **(A)** nach Anspruch 1 oder 2, wobei die Verbindung **(II)** *N,N*-Diallylethanolamin ist.

4. Zusammensetzung **(A)** nach Anspruch 1 oder 2, wobei die Verbindung **(II)** Diallylcarbamat ist.

5. Zusammensetzung **(A)** nach Anspruch 1 oder 2, umfassend als Verbindungen **(II)** sowohl *N,N*-Diallylethanolamin als auch Diallylcarbamat.

6. Zusammensetzung **(A)** nach Anspruch 5, worin das Gesamtgewicht von *N,N*-Diallylethanolamin und Diallylcarbamat in der Zusammensetzung **(A)** bezogen auf das Gesamtgewicht aller von der Zusammensetzung **(A)** umfassten Verbindungen **(I)** im Bereich 1.0 Gew.-% bis 33.7 Gew.-% liegt.

7. Zusammensetzung **(A)** nach Anspruch 6, worin das Gewichtsverhältnis der Anteile von Diallylcarbamat und *N,N*-Diallylethanolamin bei Diallylcarbamat : *N,N*-Diallylethanolamin = 99 : 1 bis 1 : 99 liegt.

8. Zusammensetzung **(B)** umfassend mindestens ein Polyolefincopolymer und eine Zusammensetzung **(A)** nach einem der Ansprüche 1 bis 7.

9. Zusammensetzung **(B)** nach Anspruch 8, wobei das Polyolefincopolymer ein Ethylen-Vinylacetat-Copolymer ist.

10. Zusammensetzung **(B)** nach Anspruch 9, wobei das Ethylen-Vinylacetat-Copolymer einen Vinylacetatgehalt von 15 bis 50 Gew.-%, bezogen auf das Gesamtgewicht des Ethylen-Vinylacetat-Copolymers, bestimmt nach ASTM D 5594:1998, aufweist.

11. Zusammensetzung **(B)** nach einem der Ansprüche 8 bis 10, worin der Anteil an Zusammensetzung **(A)** bei 0.05 bis 10 Gew.-%, bezogen auf die Masse aller von der Zusammensetzung **(B)** umfassten Polyolefincopolymere, liegt.

12. Zusammensetzung **(B)** nach einem der Ansprüche 8 bis 11, welche zusätzlich mindestens einen Initiator ausgewählt aus der Gruppe bestehend aus peroxidischen Verbindungen, Azoverbindungen, Photoinitiatoren umfasst.

13. Zusammensetzung **(B)** nach Anspruch 12, wobei der Initiator eine peroxidische Verbindung ist.

14. Zusammensetzung **(B)** nach einem der Ansprüche 8 bis 13, welche zusätzlich mindestens eine weitere Verbindung ausgewählt aus der Gruppe bestehend aus Vernetzern, Silankupplungsmitteln, Antioxidantien, Alterungsschutzmitteln, Metalloxiden, Metallhydroxiden, Weißpigmenten umfasst.

15. Zusammensetzung **(B)** nach Anspruch 14, wobei die weitere Verbindung ein Silankupplungsmittel ist.

16. Verwendung einer Zusammensetzung **(B)** nach einem der Ansprüche 8 bis 15 zur Herstellung einer Folie zur Verkapselung einer elektronischen Vorrichtung.

## Claims

1. Composition **(A)** comprising
(i) at least one compound **(I)** selected from the group consisting of triallyl isocyanurate, triallyl cyanurate; and
(ii) at least one compound **(II)** selected from the group consisting of N, N- diallylethanolamine, diallyl carbamate;
where at least one compound **(II)** encompassed by the composition **(A)** is present in a proportion of at least 0.5% by weight based on the total weight of all the compounds **(I)** encompassed by the composition **(A).**

2. Composition **(A)** according to Claim 1, wherein the compound **(I)** is triallyl isocyanurate.

3. Composition **(A)** according to Claim 1 or 2, where the compound **(II)** is N,N-diallylethanolamine.

4. Composition **(A)** according to Claim 1 or 2, where the compound **(II)** is diallyl carbamate.

5. Composition **(A)** according to Claim 1 or 2, comprising, as compounds **(II),** N,N-diallylethanolamine and diallyl carbamate.

6. Composition **(A)** according to Claim 5, in which the total weight of N,N-diallylethanolamine and diallyl carbamate in the composition **(A),** based on the total weight of all compounds **(I)** encompassed by the composition **(A),** is in the range of 1.0% by weight to 33.7% by weight.

7. Composition **(A)** according to Claim 6, in which the weight ratio of the proportions of diallyl carbamate and N,N-diallylethanolamine is diallyl carbamate:N,N-diallylethanolamine = 99:1 to 1:99.

8. Composition **(B)** comprising at least one polyolefin copolymer and a composition **(A)** according to any of Claims 1 to 7.

9. Composition **(B)** according to Claim 8, wherein the polyolefin copolymer is an ethylene-vinyl acetate copolymer.

10. Composition **(B)** according to Claim 9, wherein the ethylene-vinyl acetate copolymer has a vinyl acetate content of 15% to 50% by weight, based on the total weight of the ethylene-vinyl acetate copolymer, determined to ASTM D 5594:1998.

11. Composition **(B)** according to any of Claims 8 to 10, in which the proportion of composition **(A)** is 0.05% to 10% by weight, based on the mass of all the polyolefin copolymers encompassed by the composition **(B).**

12. Composition **(B)** according to any of Claims 8 to 11, additionally comprising at least one initiator selected from the group consisting of peroxidic compounds, azo compounds, photoinitiators.

13. Composition **(B)** according to Claim 12, wherein the initiator is a peroxidic compound.

14. Composition **(B)** according to any of Claims 8 to 13, additionally comprising at least one further compound selected from the group consisting of crosslinkers, silane coupling agents, antioxidants, ageing stabilizers, metal oxides, metal hydroxides, white pigments.

15. Composition **(B)** according to Claim 14, wherein the further compound is a silane coupling agent.

16. Use of a composition **(B)** according to any of Claims 8 to 15 for production of a film for encapsulation of an electronic device.

## Revendications

1. Composition (A) comprenant
(i) au moins un composé (I) choisi dans le groupe constitué par l'isocyanurate de triallyle, le cyanurate de triallyle ; et
(ii) au moins un composé (II) choisi dans le groupe constitué par la N,N-diallyléthanolamine, le carbamate de diallyle ;
au moins un composé (II) faisant partie de la composition (A) se trouvant en une proportion d'au moins 0,5% en poids, par rapport au poids total de tous les composés (I) faisant partie de la composition (A).

2. Composition (A) selon la revendication 1, le composé (I) étant l'isocyanurate de triallyle.

3. Composition (A) selon la revendication 1 ou 2, le composé (II) étant la N,N-diallyléthanolamine.

4. Composition (A) selon la revendication 1 ou 2, le composé (II) étant le carbamate de diallyle.

5. Composition (A) selon la revendication 1 ou 2, comprenant, comme composés (II), tant de la N,N-diallyléthanolamine que du carbamate de diallyle.

6. Composition (A) selon la revendication 5, dans laquelle le poids total de N,N-diallyléthanolamine et de carbamate de diallyle dans la composition (A), par rapport au poids total de tous les composés (I) faisant partie de la composition (A), se situe dans la plage de 1,0% en poids à 33,7% en poids.

7. Composition (A) selon la revendication 6, dans laquelle le rapport pondéral des proportions de carbamate de diallyle et de N,N-diallyléthanolamine se situe à carbamate de diallyle:N,N-diallyléthanolamine = 99:1 à 1:99.

8. Composition (B) comprenant au moins un copolymère polyoléfinique et une composition (A) selon l'une quelconque des revendications 1 à 7.

9. Composition (B) selon la revendication 8, le copolymère polyoléfinique étant un copolymère d'éthylène-acétate de vinyle.

10. Composition (B) selon la revendication 9, le copolymère d'éthylène-acétate de vinyle présentant une teneur en acétate de vinyle de 15 à 50% en poids, par rapport au poids total du copolymère d'éthylène-acétate de vinyle, déterminée selon la norme ASTM D 5594:1998.

11. Composition (B) selon l'une quelconque des revendications 8 à 10, la proportion de composition (A) se situant à 0,05 jusqu'à 10% en poids, par rapport à la masse de tous les copolymères polyoléfiniques faisant partie de la composition (B).

12. Composition (B) selon l'une quelconque des revendications 8 à 11, qui comprend en outre au moins un initiateur choisi dans le groupe constitué par les composés peroxydes, les composés azo, les photo-initiateurs.

13. Composition (B) selon la revendication 12, l'initiateur étant un composé peroxyde.

14. Composition (B) selon l'une quelconque des revendications 8 à 13, qui comprend en outre au moins un autre composé, choisi dans le groupe constitué par les réticulants, les agents de couplage de type silane, les antioxydants, les agents de protection contre le vieillissement, les oxydes métalliques, les hydroxyles métalliques, les pigments blancs.

15. Composition (B) selon la revendication 14, l'autre composé étant un agent de couplage de type silane.

16. Utilisation d'une composition (B) selon l'une quelconque des revendications 8 à 15 pour la préparation d'une feuille destinée à encapsuler un dispositif électronique.
